# EUROPEAN PATENT APPLICATION

(11) **EP 4 506 698 A1**
(43) Date of publication of application: **12.02.2025**
(21) Application number: 23795997.8
(22) Date of filing: 29.03.2023
(51) Int. Cl.: G01R 27/02

(54) **CONTACT RESISTANCE MEASUREMENT DEVICE AND IMPEDANCE MEASUREMENT DEVICE**

(30) Priority: 27.04.2022 JP 2022072944
(71) Applicant: Hioki E.E. Corporation, Ueda-shi, Nagano 386-1192 (JP)
(72) Inventor: IIJIMA Junji, Ueda-shi Nagano 386-1192 (JP); NISHIJIMA Katsutoshi, Ueda-shi Nagano 386-1192 (JP)
(74) Representative: Novagraaf International SA
(86) International application number: PCT/JP2023/012872
(87) International publication number: WO 2023/210250

(57) **Abstract**

A main object is to provide a contact resistance measurement device that can perform accurate contact check. The device includes an AC current source (SS1) for supplying a plurality of determination currents Ij defined at different frequencies (f1 to f3) to a current path including a determination target contact part, a synchronous detection unit (SDU1) for synchronously detecting a detection voltage (Vd1) corresponding to a frequency of the determination current (Ij) and generated at the determination target contact part when the determination current (Ij) is supplied from the AC current source (SS1) with synchronization signals (Sf1 to Sf3) having the same frequencies (f1 to f3) as the frequencies of the detection voltage (Vd1) and outputting a voltage (V1 to V3) whose voltage value changes according to the voltage value of each detection target (Vd1) corresponding to the different frequencies (f1 to f3), and a processing unit (CONT) for executing a quality determination process for the determination target contact part for each of the different frequencies (f1 to f3).

## Description

### TECHNICAL FIELD

The present invention relates to a contact resistance measurement device that supplies a contact determination AC current to a current path including a determination target contact part and executes a quality determination process for the determination target contact part based on a DC current voltage obtained by synchronously detecting an AC current voltage generated at the determination target contact part with a synchronization signal having the same frequency as the frequency of the AC current voltage, and an impedance measurement device that includes the contact resistance measurement device and measures an impedance of a measurement target.

### BACKGROUND ART

For example, an impedance measurement device disclosed in Patent Literature 1 below is known as an impedance measurement device including this type of contact resistance measurement device. The impedance measurement device includes a measurement signal source configured to supply a measurement signal of the AC current to a measurement target (specimen-to-be-measured) via source terminals for signal supply on a Hi side and a Lo side, and a measurement unit configured to measure a voltage, which is generated in the measurement target by the supply of the measurement signal, via each sense terminal for the signal detection on the Hi side and the Lo side. In addition, in this impedance measurement device, in order to detect the contact resistance of each sense terminal, the measurement unit includes a disconnection detection AC constant current source configured to supply an AC constant current between the sense terminal on the Hi side and the sense terminal on the Lo side, and two first and second lock-in amplifiers.

In this impedance measurement device, a frequency f11 of the AC constant current supplied from the measurement signal source and a frequency f12 of the AC constant current supplied from the disconnection detection AC constant current source are set to different frequencies, the first lock-in amplifier performs synchronous detection at the frequency f11, and the second lock-in amplifier performs synchronous detection at the frequency f12. As a result, a voltage Va generated at the measurement target by the flow of the AC constant current for measurement is output from the first lock-in amplifier, and a voltage Vb generated by the resistance between the sense terminals on the Hi side and the Lo side by the flow of the AC constant current for disconnection detection is output from the second lock-in amplifier.

In this case, when the contact resistance of the source terminal on the Hi side is RC1, the contact resistance of the source terminal on the Lo side is RC2, the contact resistance of the sense terminal on the Hi side is RC3, the contact resistance of the source terminal on the Lo side is RC4, and the impedance of the measurement target is Rx, the resistance between the sense terminals on the Hi side and the Lo side is a combined resistance of the resistance (RC3 + Rx + RC4) and the output resistance R01 of the AC constant current source. Therefore, when output resistance R01 >> resistance (RC3 + Rx + RC4) and contact resistance is (RC3 + RC4) >> impedance Rx, the contact resistance (RC3 + RC4) between the sense terminals on the Hi side and the Lo side can be detected from the voltage Vb described above, thereby enabling the contact check of the sense terminals on the Hi side and the Lo side.

### CITATION LIST

### PATENT LITERATURE

Patent Literature 1: JP 4695920 B (Page 7, FIG. 4)

### SUMMARY OF INVENTION

### TECHNICAL PROBLEM

However, the impedance measurement device described above has the following problems to be improved. Specifically, in the impedance measurement device described above, the second lock-in amplifier is used to detect the contact resistance between the sense terminals on the Hi side and the Lo side. In this case, the second lock-in amplifier performs synchronous detection at the frequency f12 of the AC constant current from the disconnection detection AC constant current source. Therefore, when noise of a frequency that is the same as or in the vicinity of the frequency f12 of the AC constant current from the disconnection detection AC constant current source is generated in the surrounding environment, an error is included in the detection of the resistance (RC3 + Rx + RC4), and the contact resistance between the sense terminals on the Hi side and the Lo side is erroneously detected. As a result, a contact check error occurs in the impedance measurement device described above, and the impedance measurement device enters an unmeasurable state. On the other hand, it is possible to forcibly enter a measurable state by canceling the setting of the contact check. However, in such a case, reliability of impedance measurement by the impedance measurement device is deteriorated. Therefore, the impedance measurement device described above has a problem to be improved, which is to enhance the accuracy of the contact check.

The present invention has been made in view of such a problem, and a main object thereof is to provide a contact resistance measurement device that can perform an accurate contact check, and an impedance measurement device that improve reliability of the impedance measurement.

### SOLUTION TO PROBLEM

In order to achieve the above object, a contact resistance measurement device according to the present invention includes a first AC current source configured to supply a contact determination AC current to a current path including a determination target contact part; a synchronous detection unit configured to synchronously detect an AC voltage corresponding to a frequency of the contact determination AC current and generated at the determination target contact part when the contact determination AC current is supplied from the first AC current source with a synchronization signal having a frequency identical to the frequency of the AC voltage and output a DC voltage whose voltage value changes according to a voltage value of the AC voltage; and a processing unit configured to execute a quality determination process for the determination target contact part based on the DC voltage output from the synchronous detection unit. The first AC current source is configured to be able to supply a plurality of the contact determination AC currents defined at different frequencies to the current path, the synchronous detection unit synchronously detects a plurality of the AC voltages generated at the determination target contact part when the plurality of the contact determination AC currents are supplied to the current path with the synchronization signals respectively having frequencies each identical to the corresponding one of the different frequencies of the plurality of the AC voltages, and outputs a plurality of the DC voltages whose voltage values change according to voltage values of the plurality of the AC voltages corresponding to the different frequencies, and the processing unit executes the quality determination process for each of the different frequencies.

Therefore, according to the contact resistance measurement device of the present invention, even when noise having a frequency that is the same as or in the vicinity of one of the different frequencies is generated in the environment around the contact resistance measurement device, the contact resistance measurement device can accurately perform the contact check as the contact check by the other frequencies is not affected.

Furthermore, in the contact resistance measurement device according to the present invention, the first AC current source is configured to be able to combine the plurality of the contact determination AC currents respectively having the different frequencies and supply the combined contact determination AC current to the current path, the synchronous detection unit is configured including a plurality of synchronous detection circuits provided in a one-to-one correspondence with the different frequencies, each of the plurality of synchronous detection circuits synchronously detects the AC voltage having a frequency corresponding to the different frequencies on a one-to-one basis with the synchronization signal having a frequency identical to the frequency of the AC voltage, and outputs the DC voltage whose voltage value changes according to the voltage value of the AC voltage corresponding to the frequency, and the processing unit executes the quality determination process for each of the different frequencies. Therefore, according to the contact resistance measurement device, as a result of simultaneously outputting the DC voltage from each synchronous detection circuit, the quality determination process can be simultaneously executed for each different frequency, and thus the contact check for the determination target contact part can be performed instantaneously (in a short time).

Furthermore, in the contact resistance measurement device according to the present invention, the synchronous detection unit sequentially and synchronously detects each of the plurality of the AC voltages with a synchronization signal having a frequency identical to the corresponding one of the different frequencies of the plurality of the AC voltages, and sequentially outputs a DC voltage whose voltage value changes according to a voltage value of each of the plurality of the AC voltages corresponding to the different frequencies, and the processing unit executes the quality determination process for each of the different frequencies. Therefore, according to this contact resistance measurement device, the synchronous detection unit can be configured simply and inexpensively as compared with a case where the synchronous detection unit is configured including a plurality of synchronous detection circuits provided in one-to-one correspondence with different frequencies.

In addition, in the contact resistance measurement device according to the present invention, the processing unit executes, as the quality determination process, a determination process for determining that a contact resistance of the determination target contact part is good for each of the different frequencies when the contact resistance of the determination target contact part is smaller than a resistance value defined in advance, and ultimately determines that the contact resistance of the determination target contact part is good when determined to be good for more than half the number of times of the executed determination process. Therefore, according to the contact resistance measurement device, even when noise having a frequency that is the same as or in the vicinity of one of the different frequencies is generated in the environment around the contact resistance measurement device, the contact resistance measurement device can accurately perform the contact check as the contact check by the other frequencies is not affected.

Furthermore, in the contact resistance measurement device according to the present invention, the processing unit executes, as the quality determination process, a determination process for determining that the contact resistance of the determination target contact part is good for each of the different frequencies when the contact resistance of the determination target contact part is smaller than a resistance value defined in advance, and ultimately determines that the contact resistance of the determination target contact part is bad when determined to be bad in all the executed determination processes. Therefore, according to the contact resistance measurement device, the contact resistance is ultimately determined to be good unless noise having a frequency that is the same as or in the vicinity of all the different frequencies is generated in the environment around the contact resistance measurement device, and thus the contact resistance measurement device can reduce the occurrence of a contact check error that determines the contact resistance of the determination target contact part as bad.

Furthermore, an impedance measurement device according to the present invention includes a second AC current source configured to supply a measurement AC current to a measurement target, the measurement target having one end and the other end connected to a Hi side source terminal and a Lo side source terminal, respectively; and a measurement unit configured to measure an AC voltage generated between the one end and the other end of the measurement target via a sense terminal for signal detection on Hi side and a sense terminal for signal detection on Lo side connected to the one end and the other end, respectively, when the measurement AC current is supplied, and measure an impedance of the measurement target based on a voltage value of the measured AC voltage and a current value of the measurement AC current, the impedance measurement device including the contact resistance measurement device according to any one of the above. The first AC current source supplies the contact determination AC current to at least one current path among the current path including a contact part between the Hi side source terminal and the one end of the measurement target and a contact part between the Lo side source terminal and the other end of the measurement target and the current path including a contact part between the sense terminal for signal detection on Hi side and the one end of the measurement target and a contact part between the sense terminal for signal detection on Lo side and the other end of the measurement target; and the processing unit executes, for each of the different frequencies, the quality determination process in which each contact part in the at least one current path is regarded as the determination target contact part. Therefore, according to this impedance measurement device, even when noise having a frequency that is the same as or in the vicinity of one of different frequencies is generated in the environment around the impedance measurement device, the contact check can be accurately performed as the contact check by other frequencies is not affected, and as a result, the reliability of the impedance measurement can be sufficiently enhanced.

In addition, in the impedance measurement device according to the present invention, the second AC current source also serves as the first AC current source, and supplies the measurement AC current as one of the plurality of the contact determination AC currents having different frequencies to the current path including the contact part between the Hi side source terminal and the one end of the measurement target and the contact part between the Lo side source terminal and the other end of the measurement target. Therefore, according to the impedance measurement device, since the second AC current source also serves as the first AC current source that supplies the contact determination AC current, it is not necessary to provide two first AC current sources, and as a result, the impedance measurement device can be configured simply and inexpensively.

Furthermore, in the impedance measurement device according to the present invention, when the processing unit ultimately determines that the contact resistance of the determination target contact part is good, the processing unit outputs the impedance of the measurement target measured by the measurement unit. Therefore, according to this impedance measurement device, the reliability of impedance measurement can be sufficiently enhanced.

### ADVANTAGEOUS EFFECTS OF INVENTION

According to the contact resistance measurement device of the present invention, even when noise having a frequency that is the same as or in the vicinity of one of the different frequencies is generated in the environment around the contact resistance measurement device, the contact resistance measurement device can accurately perform the contact check as the contact check by the other frequencies is not affected.

### BRIEF DESCRIPTION OF DRAWINGS

FIG. 1 is a configuration diagram illustrating a configuration of a contact resistance measurement device 1.
FIG. 2 is a configuration diagram illustrating a configuration of an impedance measurement device 100.
FIG. 3 is a configuration diagram illustrating a configuration of an impedance measurement device 100A.

### DESCRIPTION OF EMBODIMENTS

Hereinafter, embodiments of a contact resistance measurement device and an impedance measurement device will be described with reference to the accompanying drawings.

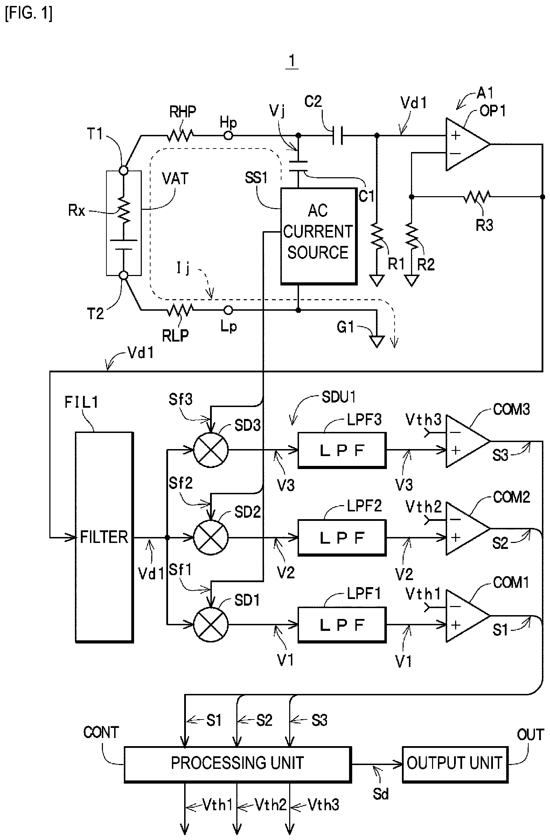

First, a contact resistance measurement device 1 will be described with reference to FIG. 1.

The contact resistance measurement device 1 is configured to be able to determine the quality of the contact resistance at the determination target contact part, and includes a pair of terminals (also referred to as a sense terminal Hp on the Hi (high) side (sense terminal for signal detection) and a sense terminal Lp on the Lo (low) side (sense terminal for signal detection)), an AC current source SS1, capacitors C1 and C2, an operational amplification arithmetic circuit A1, a filter FIL1, a synchronous detection unit SDU1, comparators COM1 to COM3, a processing unit CONT, and an output unit OUT. In this case, in the present example, for example, with a contact part between the sense terminal Hp and a positive electrode terminal T1 and a contact part between the sense terminal Lp and a negative electrode terminal T2 when the sense terminal Hp and the sense terminal Lp are respectively connected to the positive electrode terminal T1, which is one end, and the negative electrode terminal T2, which is the other end, of the battery BAT, which is a secondary battery, set as the determination target contact parts, the quality of the contact resistances RHP and RLP at each determination target contact part (whether or not smaller than a predefined resistance value) is determined.

The AC current source SS1 serves as a first AC current source, outputs, when a start signal is output from the processing unit CONT, a contact determination AC voltage Vj and starts the supply of the determination current Ij, which is an AC constant current for contact determination, to a current path including a determination target contact part, and stops, when a stop signal is output from the processing unit CONT, the output of the contact determination AC voltage Vj and stops the supply of the determination current Ij. In this case, the AC current source SS1 is configured to be able to combine a plurality of AC currents (contact determination AC currents: by way of an example, AC currents having a constant amplitude (known) and having three frequencies f1, f2, and f3 of a constant frequency different from each other) defined to different frequencies and supply the combined AC currents as the determination current Ij. However, the determination current Ij may be two AC currents having different frequencies, or may be four or more AC currents having different frequencies. Furthermore, in the present example, the determination current Ij supplied from the AC current source SS1 is supplied to the current path returning to the AC current source SS1 via a coupling capacitor C1, the sense terminal Hp, the contact part between the sense terminal Hp and the positive electrode terminal T1 (determination target contact part: contact resistance RHP), the battery BAT, the contact part between the negative electrode terminal T2 and the sense terminal Lp (determination target contact part: contact resistance RLP), and the sense terminal Lp. In addition, the AC current source SS1 outputs synchronization signals Sf1 to Sf3 having frequencies f1, f2, and f3 that are the same as the frequencies of the determination current Ij as synchronization signals for synchronous detection with respect to synchronous detection circuits SD1 to SD3 to be described below.

A first amplifier A1 serves as an AC voltage detection unit, and is configured to include an operational amplifier OP1 serving as a non-inverting amplifier in which a non-inverting input terminal is connected to the ground G1 via an input resistance R1 and connected to the sense terminal Hp via a coupling capacitor C2, an inverting input terminal is connected to the ground G1 via the input resistance R2, and a feedback resistance R3 is connected between the output terminal and the inverting input terminal. With this configuration, when the determination current Ij is supplied from the AC current source SS1, the first amplifier A1 receives an AC voltage corresponding to the frequencies f1, f2, and f3 of the determination current Ij and generated at the determination target contact part (between the sense terminal Hp and the sense terminal Lp) via the capacitor C2 and detects the AC voltage as the detection voltage Vd1 (AC voltage), and amplifies and outputs the detection voltage Vd1 at a specified amplification factor.

A filter FIL1 is configured as a narrow-band pass filter that mainly passes the AC voltage of a frequency component having the frequency f1, the AC voltage of a frequency component having the frequency f2, and the AC voltage of a frequency component having the frequency f3 contained in the detection voltage Vd1 output from the first amplifierA1. With this configuration, the filter FIL1 receives the detection voltage Vd1 output from the first amplifier A1, removes a frequency component (noise component) outside the pass band included in the detection voltage Vd1, and outputs the detection voltage Vd1.

The synchronous detection unit SDU1 includes a plurality of (three in the present example) synchronous detection circuits SD1 to SD3 provided in one-to-one correspondence with the different frequencies f1, f2, and f3, and low pass filters LPF1 to LPF3 disposed at the post-stages of the synchronous detection circuits SD1 to SD3, respectively. Here, the synchronous detection circuit SD1 and the low pass filter LPF1 serve as a synchronous detection circuit provided in one-to-one correspondence with the frequency f1, and synchronously detect the detection voltage Vd1 detected by the first amplifier A1 with the synchronization signal Sf1 having the same frequency as the frequency of the detection voltage Vd1, thereby outputting the voltage V1 that is the DC voltage whose voltage value changes according to the voltage value of the detection voltage Vd1. Specifically, the synchronous detection circuit SD1 is configured using a multiplier as an example, and multiplies the detection voltage Vd1 output from the filter FIL1 and the synchronization signal Sf1 output from the AC current source SS1 (i.e., synchronously detects the detection voltage Vd1 output from the filter FIL1 with the synchronization signal Sf1) to output the voltage V1 including a DC voltage whose voltage value changes according to a voltage value (e.g., amplitude) of the AC voltage based on the determination current Ij having the frequency f1 among the AC voltages constituting the detection voltage Vd1. In addition, the low pass filter LPF1 is configured as a low pass filter, and receives the voltage V1 output from the synchronous detection circuit SD1, removes an AC component for smoothing, and outputs the voltage V1 as a DC voltage whose voltage value changes according to the voltage value of the detection voltage Vd1 having the frequency f1. That is, the synchronous detection circuit (the synchronous detection circuit SD1 and the low pass filter LPF1) detects the magnitude of the detection voltage Vd1 corresponding to the frequency f1 of the determination current Ij.

Here, the synchronous detection circuit SD2 and the low pass filter LPF2 serve as a synchronous detection circuit provided in one-to-one correspondence with the frequency f2, and synchronously detect the detection voltage Vd1 detected by the first amplifier A1 with the synchronization signal Sf2 having the same frequency as the frequency of the detection voltage Vd1, thereby outputting the voltage V2 that is the DC voltage whose voltage value changes according to the voltage value of the detection voltage Vd1. Specifically, the synchronous detection circuit SD2 is configured using a multiplier as an example, and multiplies the detection voltage Vd1 output from the filter FIL1 and the synchronization signal Sf2 output from the AC current source SS1 (i.e., synchronously detects the detection voltage Vd1 output from the filter FIL1 with the synchronization signal Sf2) to output the voltage V2 including a DC voltage whose voltage value changes according to a voltage value (e.g., amplitude) of the AC voltage based on the determination current Ij having the frequency f2 among the AC voltages constituting the detection voltage Vd1. In addition, the low pass filter LPF2 is configured as a low pass filter, and receives the voltage V2 output from the synchronous detection circuit SD2, removes an AC component for smoothing, and outputs the voltage V2 as a DC voltage whose voltage value changes according to the voltage value of the detection voltage Vd1 having the frequency f2. That is, the synchronous detection circuit (the synchronous detection circuit SD2 and the low pass filter LPF2) detects the magnitude of the detection voltage Vd1 corresponding to the frequency f2 of the determination current Ij.

Here, the synchronous detection circuit SD3 and the low pass filter LPF3 serve as a synchronous detection circuit provided in one-to-one correspondence with the frequency f3, and synchronously detect the detection voltage Vd1 detected by the first amplifier A1 with the synchronization signal Sf3 having the same frequency as the frequency of the detection voltage Vd1, thereby outputting the voltage V3 that is the DC voltage whose voltage value changes according to the voltage value of the detection voltage Vd1. Specifically, the synchronous detection circuit SD3 is configured using a multiplier as an example, and multiplies the detection voltage Vd1 output from the filter FIL1 and the synchronization signal Sf3 output from the AC current source SS1 (i.e., synchronously detects the detection voltage Vd1 output from the filter FIL1 with the synchronization signal Sf3) to output the voltage V3 including a DC voltage whose voltage value changes according to a voltage value (e.g., amplitude) of the AC voltage based on the determination current Ij having the frequency f3 among the AC voltages constituting the detection voltage Vd1. In addition, the low pass filter LPF3 is configured as a low pass filter, and receives the voltage V3 output from the synchronous detection circuit SD3, removes an AC component for smoothing, and outputs the voltage V3 as a DC voltage whose voltage value changes according to the voltage value of the detection voltage Vd1 having the frequency f3. That is, the synchronous detection circuit (the synchronous detection circuit SD3 and the low pass filter LPF3) detects the magnitude of the detection voltage Vd1 corresponding to the frequency f3 of the determination current Ij.

The comparator COM1 constitutes a "processing unit" together with the other comparators COM2 and COM3 and the processing unit CONT. In this case, as an example, the comparator COM1 is configured by an operational amplifier, has a threshold voltage Vth1 of a voltage defined in advance set to the inverting input terminal by the processing unit CONT, and outputs, when the voltage V1 output from the low pass filter LPF1 and input to the non-inverting input terminal exceeds the voltage value of the threshold voltage Vth1, a high (high voltage) determination signal S1. In this case, since the voltage V1 is obtained by detecting the voltage (i.e., the magnitude of the AC voltage corresponding to the frequency f1 of the determination current Ij) generated between the sense terminal Hp and the sense terminal Lp based on the determination current Ij having the frequency f1 among the voltages included in the detection voltage Vd1, the voltage value is a value (∝ RHP + Rx + RLP) proportional to the series combined resistance (RHP + Rx + RLP) of the internal resistance Rx (resistance value is Rx) of the battery BAT, the contact resistance RHP (resistance value is RHP), and the contact resistance RLP (resistance value is RLP). When contact resistance (RHP + RLP) >> internal resistance (Rx), the voltage V1 is a voltage whose voltage value indicates the magnitude of the contact resistance (RHP + RLP). Therefore, by defining the threshold voltage Vth1 to a voltage value corresponding to the maximum resistance value allowed for the contact resistance (RHP + RLP), the comparator COM1 outputs the high determination signal S1 when the contact resistance (RHP + RLP) between the sense terminal Hp and the sense terminal Lp is a large resistance value exceeding the maximum resistance value allowed (i.e., when the contact is bad). On the contrary, the comparator COM1 outputs the low (low voltage) determination signal S1 when the contact resistance (RHP + RLP) is a small resistance value less than or equal to the maximum resistance value allowed (i.e., when the contact is good).

As an example, the comparator COM2 is configured by an operational amplifier, has a threshold voltage Vth2 of a voltage defined in advance set to the inverting input terminal by the processing unit CONT, and outputs, when the voltage V2 output from the low pass filter LPF2 and input to the non-inverting input terminal exceeds the voltage value of the threshold voltage Vth2, a high (high voltage) determination signal S2. In this case, since the voltage V2 is obtained by detecting the voltage (i.e., the magnitude of the AC voltage corresponding to the frequency f2 of the determination current Ij) generated between the sense terminal Hp and the sense terminal Lp based on the determination current Ij having the frequency f2 among the voltages included in the detection voltage Vd1, the voltage value is a value (∝ RHP + Rx + RLP) proportional to the series combined resistance (RHP + Rx + RLP) of the internal resistance Rx of the battery BAT, the contact resistance RHP, and the contact resistance RLP. When contact resistance (RHP + RLP) >> internal resistance (Rx), the voltage V2 is a voltage whose voltage value indicates the magnitude of the contact resistance (RHP + RLP). Therefore, by defining the threshold voltage Vth2 to a voltage value corresponding to the maximum resistance value allowed for the contact resistance (RHP + RLP), the comparator COM2 outputs the high determination signal S2 when the contact resistance (RHP + RLP) between the sense terminal Hp and the sense terminal Lp is a large resistance value exceeding the maximum resistance value allowed (i.e., when the contact is bad). On the contrary, the comparator COM2 outputs the low (low voltage) determination signal S2 when the contact resistance (RHP + RLP) is a small resistance value less than or equal to the maximum resistance value allowed (i.e., when the contact is good).

As an example, the comparator COM3 is configured by an operational amplifier, has a threshold voltage Vth3 of a voltage defined in advance set to the inverting input terminal by the processing unit CONT, and outputs, when the voltage V3 output from the low pass filter LPF3 and input to the non-inverting input terminal exceeds the voltage value of the threshold voltage Vth3, a high (high voltage) determination signal S3. In this case, since the voltage V3 is obtained by detecting the voltage (i.e., the magnitude of the AC voltage corresponding to the frequency f3 of the determination current Ij) generated between the sense terminal Hp and the sense terminal Lp based on the determination current Ij having the frequency f3 among the voltages included in the detection voltage Vd1, the voltage value is a value (∝ RHP + Rx + RLP) proportional to the series combined resistance (RHP + Rx + RLP) of the internal resistance Rx of the battery BAT, the contact resistance RHP, and the contact resistance RLP. When contact resistance (RHP + RLP) >> internal resistance (Rx), the voltage V3 is a voltage whose voltage value indicates the magnitude of the contact resistance (RHP + RLP). Therefore, by defining the threshold voltage Vth3 to a voltage value corresponding to the maximum resistance value allowed for the contact resistance (RHP + RLP), the comparator COM3 outputs the high determination signal S3 when the contact resistance (RHP + RLP) between the sense terminal Hp and the sense terminal Lp is a large resistance value exceeding the maximum resistance value allowed (i.e., when the contact is bad). On the contrary, the comparator COM3 outputs the low (low voltage) determination signal S3 when the contact resistance (RHP + RLP) is a small resistance value less than or equal to the maximum resistance value allowed (i.e., when the contact is good). Note that the above-described comparison processing between the voltages V1 to V3 and the threshold voltages Vth1 to Vth3 by the comparators COM1 to COM3 corresponds to "Part of quality determination process executed for each of the different frequencies on the determination target contact part based on the DC voltage (in the present example, the voltages V1 to V3) output from the synchronous detection unit".

The processing unit CONT includes, for example, a CPU, serves as a "processing unit" together with the comparators COM1 to COM3, and executes, for each of the different frequencies f1, f2, and f3, the quality determination process for the determination target contact part (in the present example, contact resistance (RHP + RLP) between the sense terminal Hp and the sense terminal Lp) based on the voltages V1 to V3 that are the DC voltage whose voltage values change according to the voltage value of the detection voltage Vd1 (in the present example, the detection voltage Vd1 having the frequencies f1, f2, and f3) that is the AC voltage detected by the first amplifier A1. Specifically, based on the determination signals S1 to S3 output from the comparators COM1 to COM3, the processing unit CONT determines whether or not the contact resistance (RHP + RLP) at the determination target contact part is a small resistance value less than or equal to the allowable maximum resistance value (i.e., the quality of contact of the determination target contact part). In addition, the processing unit CONT outputs the display data Sd representing the processing result of the quality determination process to the output unit OUT. Furthermore, the processing unit CONT outputs the above-described threshold voltages Vth1 to Vth3 to the corresponding comparators COM1 to COM3.

Note that the comparators COM1 to COM3 may be configured using an internal circuit of the processing unit CONT, and in a case where such a configuration is adopted, the arrangement of the comparators COM1 to COM3 at the post-stage of the low pass filters LPF1 to LPF3 is omitted, and the voltages V1 to V3 output from the low pass filters LPF1 to LPF3 are directly input to the processing unit CONT. In addition, in the present example, the determination signals S1 to S3 are generated using the comparators COM1 to COM3, but a configuration in which the voltages V1 to V3 output from the low pass filters LPF1 to LPF3 are directly input to the processing unit CONT, an arithmetic circuit including an A/D converter inside the processing unit CONT calculates voltage values of the voltages V1 to V3, and determines whether or not the contact resistance (RHP + RLP) at the determination target contact part is a small resistance value less than or equal to the maximum resistance value allowed (i.e., the quality of contact of the determination target contact part) can be adopted. In this case, when contact resistance (RHP + RLP) >> internal resistance (Rx), the processing unit CONT calculates the contact resistance (RHP + RLP) by dividing the voltage values of the voltages V1 to V3 by the known current value of the determination current Ij. In addition, when calculating (measuring) the contact resistance (RHP + RLP), the processing unit CONT can display the contact resistance (RHP + RLP) by outputting the display data Sd including data for displaying the contact resistance (RHP + RLP) to the output unit OUT. Note that the processing unit CONT can also adopt a configuration in which only the calculation of the contact resistance (RHP + RLP) and the output of the display data Sd to the output unit OUT are performed, and the quality of contact of the determination target contact part is not determined, that is, a configuration in which the determination of the quality of contact of the determination target contact part is left to the measurer based on the contact resistance (RHP + RLP) displayed on the output unit OUT. In this case, the calculation of the contact resistance (RHP + RLP) and the output of the display data Sd to the output unit OUT correspond to the quality determination process.

As an example, the output unit OUT includes a display device, receives the display data Sd output from the processing unit CONT, and displays the quality of contact of the determination target contact part. Furthermore, when the display data Sd including data for displaying the contact resistance (RHP + RLP) is input, the output unit OUT displays the resistance value of the contact resistance (RHP + RLP). Note that the output unit OUT can be configured by various interface circuits instead of the display device. When configured by the external interface circuit, the output unit OUT outputs the quality of contact of the determination target contact part and the resistance value of the contact resistance (RHP + RLP) to an external device connected with a transmission path via the external interface circuit. When configured by the medium interface circuit, the output unit OUT causes a storage medium connected to the medium interface circuit to store the quality of contact of the determination target contact part and the resistance value of the contact resistance (RHP + RLP).

Next, the operation of the contact resistance measurement device 1 will be described with reference to FIG. 1. Note that it is assumed that the sense terminal Hp and the sense terminal Lp are respectively connected to the positive electrode terminal T1 and the negative electrode terminal T2 of the battery BAT via two measurement cables (not illustrated). In addition, the contact resistance between the sense terminal Hp and the positive electrode terminal T1 of the B battery BAT and the wiring resistance of the measurement cable are referred to as contact resistance RHP, and the contact resistance between the sense terminal Lp and the negative electrode terminal T2 of the battery BAT and the wiring resistance of the measurement cable are referred to as contact resistance RLP. Furthermore, the wiring resistance of the measurement cable is ignored in the description of present example because it is a small resistance.

When the quality determination process for the determination target contact part is executed, the processing unit CONT outputs a start signal to the AC current source SS1 and outputs threshold voltages Vth1 to Vth3 corresponding to the comparators COM1 to COM3. At this time, by outputting the contact determination AC voltage Vj, the AC current source SS1 starts supplying the determination current Ij obtained by combining the AC currents having the frequencies f1, f2, and f3 to the current path described above including the determination target contact part via the capacitor C1, and outputs the synchronization signals Sf1 to Sf3 to the synchronous detection circuits SD1 to SD3, respectively. As a result, when the determination current Ij is supplied between the sense terminal Hp and the sense terminal Lp, an AC voltage caused by the determination current Ij having the frequencies f1, f2, and f3 flowing to the determination target contact parts between the sense terminal Hp and the positive electrode terminal T1 of the battery BAT and between the negative electrode terminal T2 of the battery BAT and the sense terminal Lp is generated. In this case, the generated AC voltage is input as the detection voltage Vd1 to the non-inverting input terminal of the operational amplifier OP1 via the capacitor C2. Next, the first amplifier A1 amplifies the input detection voltage Vd1 with a prescribed amplification factor and outputs the amplified detection voltage Vd1 to the filter FIL1.

Next, the filter FIL1 receives the detection voltage Vd1 output from the first amplifier A1, and passes, as the detection voltage Vd1, AC voltages that are frequency components of the frequencies f1, f2, and f3 included in the detection voltage Vd1 while removing frequency components (noise components) outside the pass band included in the detection voltage Vd1. Thereafter, the detection voltage Vd1, which is the frequency components of the frequencies f1, f2, and f3 that have passed through the filter FIL1, is input to the synchronous detection circuits SD1 to SD3.

Next, the synchronous detection circuit SD1 synchronously detects the input detection voltage Vd1 with the synchronization signal Sf1 output from the AC current source SS1, and outputs a voltage V1 whose voltage value changes according to the voltage value (e.g., amplitude) of the AC voltage based on the determination current Ij having the frequency f1 among the AC voltages constituting the detection voltage Vd1. Thereafter, the low pass filter LPF1 receives the voltage V1 output from the synchronous detection circuit SD1, removes the AC component for smoothing, and outputs the voltage V1 that is the DC voltage to the non-inverting terminal of the comparator COM1. Next, the synchronous detection circuit SD2 synchronously detects the input detection voltage Vd1 with the synchronization signal Sf2 output from the AC current source SS1, and outputs a voltage V2 whose voltage value changes according to the voltage value (e.g., amplitude) of the AC voltage based on the determination current Ij having the frequency f2 among the AC voltages constituting the detection voltage Vd1. Thereafter, the low pass filter LPF2 receives the voltage V2 output from the synchronous detection circuit SD2, removes the AC component for smoothing, and outputs the voltage V2 that is the DC voltage to the non-inverting terminal of the comparator COM2. Furthermore, the synchronous detection circuit SD3 synchronously detects the input detection voltage Vd1 with the synchronization signal Sf3 output from the AC current source SS1, and outputs a voltage V3 whose voltage value changes according to the voltage value (e.g., amplitude) of the AC voltage based on the determination current Ij having the frequency f3 among the AC voltages constituting the detection voltage Vd1. Thereafter, the low pass filter LPF3 receives the voltage V3 output from the synchronous detection circuit SD3, removes the AC component for smoothing, and outputs the voltage V3 that is the DC voltage to the non-inverting terminal of the comparator COM3.

Next, as a part of the quality determination process, the comparator COM1 compares the voltage V1 input to the non-inverting terminal with the threshold voltage Vth1 input to the inverting terminal, outputs a high (high voltage) determination signal S1 when the voltage V1 exceeds the voltage value of the threshold voltage Vth1, and outputs a low (low voltage) determination signal S1 to the processing unit CONT when the voltage V1 is less than or equal to the voltage value of the threshold voltage Vth1. In this case, when noise having a frequency that is the same as or in the vicinity of the frequency f1 is generated in the environment around the contact resistance measurement device 1, the voltage value of the voltage V1 increases, so that the voltage V1 exceeds the voltage value of the threshold voltage Vth1, and as a result, the comparator COM1 outputs a high (high voltage) determination signal S1 indicating that the contact resistance is bad. Next, as a part of the quality determination process, the comparator COM2 compares the voltage V2 input to the non-inverting terminal with the threshold voltage Vth2 input to the inverting terminal, outputs a high (high voltage) determination signal S2 when the voltage V2 exceeds the voltage value of the threshold voltage Vth2, and outputs a low (low voltage) determination signal S2 to the processing unit CONT when the voltage V2 is less than or equal to the voltage value of the threshold voltage Vth2. In this case, when noise having a frequency that is the same as or in the vicinity of the frequency f2 is generated in the environment around the contact resistance measurement device 1, the voltage value of the voltage V2 increases, so that the voltage V2 exceeds the voltage value of the threshold voltage Vth2, and as a result, the comparator COM2 outputs a high (high voltage) determination signal S2 indicating that the contact resistance is bad. Next, as a part of the quality determination process, the comparator COM3 compares the voltage V3 input to the non-inverting terminal with the threshold voltage Vth3 input to the inverting terminal, outputs a high (high voltage) determination signal S3 when the voltage V3 exceeds the voltage value of the threshold voltage Vth3, and outputs a low (low voltage) determination signal S3 to the processing unit CONT when the voltage V1 is less than or equal to the voltage value of the threshold voltage Vth1. In this case, when noise having a frequency that is the same as or in the vicinity of the frequency f3 is generated in the environment around the contact resistance measurement device 1, the voltage value of the voltage V3 increases, so that the voltage V3 exceeds the voltage value of the threshold voltage Vth3, and as a result, the comparator COM3 outputs a high (high voltage) determination signal S3 indicating that the contact resistance is bad.

Next, the processing unit CONT executes the quality determination process for each of the different frequencies f1, f2, and f3 based on the input determination signals S1 to S3. Specifically, the processing unit CONT ultimately determines the quality of the contact resistance of the determination target contact part as the quality determination process based on the result of the comparison between the voltages V1, V2, and V3 and the threshold voltages Vth1, Vth2, and Vth3 (the determination process which is a process of a part of the quality determination process) performed by the comparators COM1 to COM3, respectively. More specifically, as the quality determination process, the processing unit CONT ultimately determines that the contact resistance of the determination target contact part is good when the contact resistance of the determination target contact part is a small resistance value less than or equal to a resistance value defined in advance (resistance value corresponding to the threshold voltages Vth1 to Vth3) in more than half the number of times (two or more times in this example) of the plurality of times (three times in this example) of the determination process executed by the comparators COM1 to COM3 for each of the different frequencies f1, f2, and f3, that is, when determined to be good and two or more of the low determination signals S1 to S3 are output. On the other hand, the processing unit CONT ultimately determines that the contact resistance of the determination target contact part is bad when the contact resistance of the determination target contact part is a small resistance value less than or equal to a resistance value defined in advance (resistance value corresponding to the threshold voltages Vth1 to Vth3) in less than half (less than twice in this example) of the plurality of times (three times in this example) of determination process by the comparators COM1 to COM3, that is, when determined to be good and less than two of the low determination signals S1 to S3 are output. By executing the quality determination process in this manner, even when noise having a frequency that is the same as or in the vicinity of one frequency (e.g., frequency f1) is generated in the environment around the contact resistance measurement device 1, the contact resistance measurement device 1 (processing unit CONT) can accurately perform the contact check as contact checks by other frequencies (in this example, the frequencies f2, f3) are not affected.

Note that the following process can also be executed as the quality determination process of the processing unit CONT. Specifically, as the quality determination process, the processing unit CONT ultimately determines that the contact resistance of the determination target contact part is bad when the contact resistance of the determination target contact part has a large resistance value exceeding a resistance value defined in advance (threshold voltages Vth1 to Vth3) in all (three times in this example) of the plurality of times (three times in this example) of determination process by the comparators COM1 to COM3 executed for each of the different frequencies f1, f2, and f3 (i.e., when determined to be bad), and ultimately determines that the contact resistance of the determination target contact part is good when the contact resistance of the determination target contact part has a small resistance value less than or equal to the resistance value defined in advance (threshold voltages Vth1 to Vth3) in at least one of the plurality of times (three times in this example) of determination process by the comparators COM1 to COM3. By executing the quality determination process in this manner, unless noises having frequencies that are the same as or in the vicinity of all the three frequencies f1, f2, and f3 are generated in the environment around the contact resistance measurement device 1, the contact resistance is ultimately determined to be good, and thus the contact resistance measurement device 1 (processing unit CONT) can reduce the occurrence of a contact check error that determines that the contact resistance of the determination target contact part as bad.

Thereafter, the processing unit CONT outputs the final determination result of the quality determination process to the output unit OUT as the display data Sd. Next, based on the display data Sd, the output unit OUT displays whether or not the contact resistance (RHP + RLP) of the determination target contact part is a resistance value smaller than the maximum resistance value allowed, that is, the quality of the contact resistance of the determination target contact part. In this case, when the contact resistance of the determination target contact part is displayed as bad, a warning display can be displayed together. In addition, a configuration in which an audio output unit is provided in the output unit OUT to output a warning sound may be adopted.

Note that it is also possible to adopt a configuration in which the processing unit CONT includes only determination results of a plurality of times (three times in this example) of determination process by the comparators COM1 to COM3 in the display data Sd and outputs the display data to the output unit OUT. When this configuration is adopted, the measurer makes a determination based on the determination result of the determination process.

As described above, according to the contact resistance measurement device 1, the AC current source SS1 supplies the plurality of determination currents Ij defined at different frequencies to the current path, the synchronous detection circuits SD1 to SD3 and the low pass filters LPF1 to LPF3 synchronously detect the respective detection voltages Vd1 (AC voltages respectively corresponding to frequencies f1, f2, and 3 of the detection voltage Vd1) corresponding to the different frequencies f1, f2, and 3 generated at the determination target contact part when the plurality of determination currents Ij are supplied to the current path described above with the synchronization signals Sf1 to Sf3 having the same frequency as the frequencies f1, f2, and 3, respectively to output the voltages V1 to V3 whose voltage values change according to the voltage values of the detection voltages Vd1 corresponding to the frequencies f1, f2, and 3, and the processing unit CONT executes the quality determination process for each of the frequencies f1, f2, and 3. As a result, even when noise having a frequency that is the same as or in the vicinity of one frequency (e.g., frequency f1) of the different frequencies is generated in the environment around the contact resistance measurement device 1, the contact resistance measurement device 1 (processing unit CONT) can accurately perform the contact check as contact checks by other frequencies (in this example, the frequencies f2, f3) are not affected.

Furthermore, according to the contact resistance measurement device 1, the AC current source SS1 synthesizes a plurality of contact determination AC currents (determination current Ij at frequencies f1, f2, f3) having different frequencies and supplies the synthesized AC currents to a current path, each of a plurality of synchronous detection circuits (synchronous detection circuits SD1 to SD3 and low pass filters LPF1 to LPF3) provided in one-to-one correspondence with the different frequencies f1, f2, and f3 synchronously detects a detection voltage Vd1 having a frequency (any of the frequencies f1, f2, and f3) corresponding one-to-one to the different frequencies f1, f2, and f3 with a synchronization signal (any corresponding one of synchronization signals Sf1 to Sf3) having the same frequency (any of the frequencies f1, f2, and f3) as the frequency of the detection voltage Vd1 to output a DC voltage (any one of voltages V1 to V3) whose voltage value changes according to the voltage value of the detection voltage Vd1 corresponding to the frequency (any of the frequencies f1, f2, and f3), and the processing unit CONT executes the quality determination process for each of the different frequencies f1, f2, and f3. Therefore, according to the contact resistance measurement device 1, as a result of the voltages V1 to V3, which are DC voltages, being simultaneously output from the synchronous detection circuits (SD1 to SD3 and the low pass filters LPF1 to LPF3), the quality determination process can be simultaneously executed for each of the different frequencies f1, f2, and f3, so that the contact check for the determination target contact part can be performed instantaneously (in a short time).

In addition, according to the contact resistance measurement device 1, the processing unit (the comparators COM1 to COM3 and the processing unit CONT) executes, for each of the different frequencies f1, f2, and f3, the determination process of determining that the contact resistance of the determination target contact part is good when the contact resistance (RHP + RLP) of the determination target contact part (between the sense terminal Hp and the sense terminal Lp) is smaller than the resistance value defined in advance as the quality determination process, and ultimately determines that the contact resistance (RHP + RLP) of the determination target contact part is good when it is determined that the contact resistance is good for the number of times exceeding half of the number of times the determination process has been executed. Therefore, according to the contact resistance measurement device 1, even when noise having a frequency that is the same as or in the vicinity of one frequency (e.g., frequency f1) is generated in the environment around the contact resistance measurement device 1, the contact resistance measurement device 1 (processing unit CONT) can accurately perform the contact check as contact checks by other frequencies (in this example, the frequencies f2, f3) are not affected.

In addition, according to the contact resistance measurement device 1, the processing unit (the comparators COM1 to COM3 and the processing unit CONT) executes, for each of the different frequencies f1, f2, and f3, the determination process of determining that the contact resistance of the determination target contact part is good when the contact resistance (RHP + RLP) of the determination target contact part (between the sense terminal Hp and the sense terminal Lp) is smaller than the resistance value defined in advance as the quality determination process, and ultimately determines that the contact resistance (RHP + RLP) of the determination target contact part is bad when it is determined a bad in all the executed determination processes. Therefore, according to the contact resistance measurement device 1, the contact resistance is ultimately determined to be good unless noises having frequencies that are the same as or in the vicinity of all the different frequencies f1, f2, and f3 are generated in the environment around the contact resistance measurement device 1, and thus the contact resistance measurement device 1 can reduce the occurrence of a contact check error that determines the contact resistance of the determination target contact part as bad.

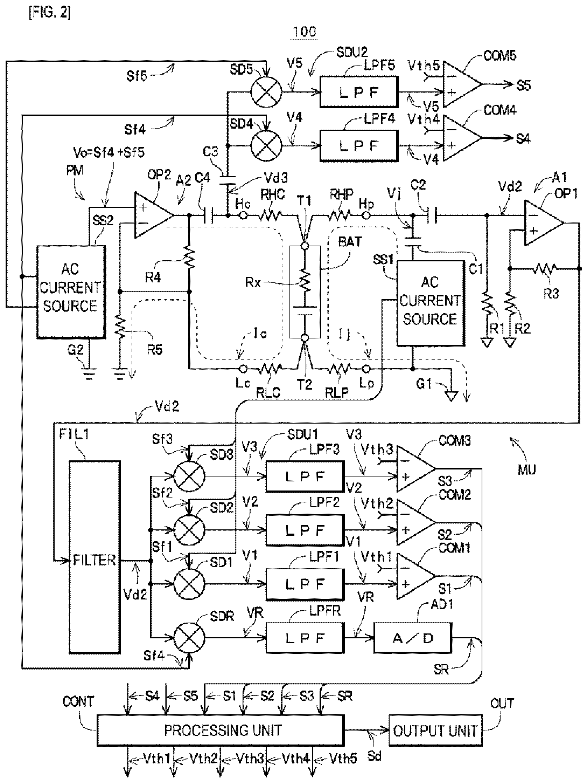

Next, an impedance measurement device that includes the contact resistance measurement device 1 described above and measures the impedance to be measured will be described with reference to FIG. 2. Note that components having the same functions as those of the contact resistance measurement device 1 described above are denoted by the same reference numerals, and redundant description will be omitted.

The impedance measurement device 100 includes a source terminal Hc on the Hi side (source terminal for supplying a measurement AC signal), a source terminal Lc on the Lo side (source terminal for supplying a measurement AC signal), a measurement AC current source PM, a capacitor C3, a synchronous detection unit SDU2, comparators COM4 and COM5, and a measurement unit MU, and is configured to be able to measure an internal resistance Rx of a battery BAT serving as an example of impedance in a state where the source terminal Hc on the Hi side and the sense terminal Hp on the Hi side are connected to a positive electrode terminal T1 (one electrode) of the battery BAT as an example of a measurement target (e.g., connected via a measurement cable (not illustrated)), and the source terminal Lc on the Lo side and the sense terminal Lp on the Lo side are connected to a negative electrode terminal T2 (the other electrode) of the battery BAT (e.g., connected via a measurement cable (not illustrated)).

The measurement AC current source PM serves as a first AC current source and a second AC current source, and supplies the output AC current Io to the battery BAT connected between the source terminals Hc and Lc on the Hi side and the Lo side, respectively. As an example, the measurement AC current source PM includes an AC current source SS2, an operational amplifier OP2, a feedback resistance 4, a ground resistance 5, and a coupling capacitor C4. In addition, the measurement AC current source PM operates based on a DC voltage (DC voltage (DC positive voltage and DC negative voltage) based on the potential of the ground G2 having a potential different from that of the ground G1) supplied from a power source system (not illustrated) for the measurement AC current source PM.

When a measurement start signal is output from the processing unit CONT, the AC current source SS2 outputs the AC voltage Vo and starts supplying the output AC current Io, which is an AC constant current for measurement and contact determination, to the current path including the battery BAT, and when a measurement stop signal is output from the processing unit CONT, stops the output of the AC voltage Vo and stops supplying the output AC current Io. In this case, the AC current source SS1 is configured to be able to combine a plurality of AC currents (as an example, AC currents having two frequencies f4, f5 different from each another with a constant amplitude (known) and at a constant frequency) having different frequencies, and supply the combined AC current as the output AC current Io. Note that the AC current having the frequency f4 is used as the measurement AC current and the contact determination AC current, and the AC current having the frequency f5 is used as the contact determination AC current. In addition, the frequencies f4 and f5 are defined as frequencies different from the frequencies f1, f2, and f3 described above. In addition, the AC current source SS2 outputs synchronization signals Sf4 and Sf5 having frequencies f4 and f5 that are the same as the frequency of the output AC current Io as synchronization signals for synchronous detection to synchronous detection circuits SD4 and SD5 to be described below, and outputs a synchronization signal Sf4 having a frequency f4 as a synchronization signal for synchronous detection to a synchronous detection circuit SDR to be described below. Note that the AC current source SS2 may be configured to be able to combine, not limited to the two output AC currents Io having the frequencies f4 and f5, three or more AC currents having frequencies different from the frequencies f1, f2, and f3 and having mutually different frequencies and supply the combined AC current as the output AC current Io.

In the operational amplifier OP2, the feedback resistance R4 is connected between the output terminal and the inverting input terminal, the inverting input terminal is connected to the ground G2 via the ground resistance R5, and the AC voltage Vo input to the non-inverting input terminal is amplified and output. Furthermore, the operational amplifier OP2 has an output terminal connected to the source terminal Hc via the capacitor C4, and an inverting input terminal connected to the source terminal Lc. With this configuration, the operational amplifier OP2 can supply, as the output AC current Io, an AC constant current having a known current value obtained by dividing the voltage value of the AC voltage Vo by the resistance value of the ground resistance 5 to the battery BAT connected between the source terminals Hc and Lc. Furthermore, since the ground G2 serving as the reference of the DC voltage (DC positive voltage and the DC negative voltage for operation) described above for the measurement AC current source PM is electrically separated from the ground G1 serving as the reference of the DC voltage (DC positive voltage and the DC negative voltage for operation) for the measurement unit MU, the output AC current Io flows only to the path from the output terminal of the operational amplifier OP2 to the ground G2 via the capacitor C4, the source terminal Hc, the battery BAT, the source terminal Lc, and the ground resistance 5, as illustrated in FIG. 2. Note that since the battery BAT of the present example is a battery that generates a DC electromotive force, the capacitor C4 is provided in order to avoid a situation in which the DC electromotive force is applied to the output terminal of the operational amplifier OP2. Therefore, when the measurement target does not generate the DC electromotive force, a configuration in which the output terminal of the operational amplifier OP2 is directly connected to the source terminal Hc without providing the capacitor C4 can be adopted.

The synchronous detection unit SDU2 includes a plurality of (two in the present example) synchronous detection circuits SD4 and SD5 provided in one-to-one correspondence with the different frequencies f4 and f5, and low pass filters LPF4 and LPF5 disposed at the post-stages of the synchronous detection circuits SD4 and SD5, respectively. Here, the synchronous detection circuit SD4 and the low pass filter LPF4 serve as a synchronous detection circuit provided in one-to-one correspondence with the frequency f4, and synchronously detect the AC voltage Vd3 generated at the source terminal Hc when the output AC current Io is supplied from the measurement AC current source PM with the synchronization signal Sf4 having the same frequency as the frequency of the detection voltage Vd3, thereby outputting the voltage V4 that is DC voltage whose voltage value changes according to the voltage value of the detection voltage Vd3. Specifically, the synchronous detection circuit SD4 is configured using a multiplier as an example, and multiplies the detection voltage Vd3 and the synchronization signal Sf4 that is output from the AC current source SS2 (i.e., synchronously detects the detection voltage Vd3 with the synchronization signal Sf4) to output the voltage V4 including a DC voltage whose voltage value changes according to a voltage value (e.g., amplitude) of the AC voltage based on the output AC current Io having the frequency f4 of the AC voltage constituting the detection voltage Vd3. In addition, the low pass filter LPF4 is configured as a low pass filter, and receives the voltage V4 output from the synchronous detection circuit SD4, removes an AC component for smoothing, and outputs the voltage V4 as a DC voltage whose voltage value changes according to the voltage value of the detection voltage Vd3 having the frequency f4. That is, the synchronous detection circuit (the synchronous detection circuit SD4 and the low pass filter LPF4) detects the magnitude of the detection voltage Vd3 corresponding to the frequency f4 of the output AC current Io.

The synchronous detection circuit SD5 and the low pass filter LPF5 serve as a synchronous detection circuit provided in one-to-one correspondence with the frequency f5, and synchronously detect the AC voltage Vd3 generated at the source terminal Hc when the output AC current Io is supplied from the measurement AC current source PM with the synchronization signal Sf5 having the same frequency as the frequency of the detection voltage Vd3, thereby outputting the voltage V5 that is DC voltage whose voltage value changes according to the voltage value of the detection voltage Vd3. Specifically, the synchronous detection circuit SD5 is configured using a multiplier as an example, and multiplies the detection voltage Vd3 and the synchronization signal Sf5 that is output from the AC current source SS2 (i.e., synchronously detects the detection voltage Vd3 with the synchronization signal Sf5) to output the voltage V5 including a DC voltage whose voltage value changes according to a voltage value (e.g., amplitude) of the AC voltage based on the output AC current Io having the frequency f5 of the AC voltage constituting the detection voltage Vd3. In addition, the low pass filter LPF5 is configured as a low pass filter, and receives the voltage V5 output from the synchronous detection circuit SD5, removes an AC component for smoothing, and outputs the voltage V5 as a DC voltage whose voltage value changes according to the voltage value of the detection voltage Vd3 having the frequency f5. That is, the synchronous detection circuit (the synchronous detection circuit SD5 and the low pass filter LPF5) detects the magnitude of the detection voltage Vd3 corresponding to the frequency f5 of the output AC current Io.

The comparator COM4 constitutes a "processing unit" together with the comparators COM1 to COM3 and COM5 and the processing unit CONT. In this case, as an example, the comparator COM4 is configured by an operational amplifier, has a threshold voltage Vth4 of a voltage defined in advance set to the inverting input terminal by the processing unit CONT, and outputs, when the voltage V4 output from the low pass filter LPF4 and input to the non-inverting input terminal exceeds the voltage value of the threshold voltage Vth4, a high (high voltage) determination signal S4. In this case, since the voltage V4 is obtained by detecting the voltage (i.e., the magnitude of the AC voltage corresponding to the frequency f4 of the output AC current Io) generated between the source terminal Hc and the ground G2 based on the output AC current Io having the frequency f4 among the voltages included in the detection voltage Vd3, the voltage value thereof is a value (∝ RHC + Rx + RLC) proportional to the series combined resistance (RHC + Rx + RLC) of the internal resistance Rx (resistance value is Rx) of the battery BAT, and the contact resistance RHC (resistance value is RHC) and the contact resistance RLC (resistance value is RLC). Furthermore, when contact resistance (RHC + RLC) >> internal resistance (Rx), the voltage V4 has a voltage value indicating the magnitude of the contact resistance (RHC + RLC). Therefore, by defining the threshold voltage Vth4 to a voltage value corresponding to the maximum resistance value allowed for the contact resistance (RHC + RLC), the comparator COM4 outputs the high determination signal S4 when the contact resistance (RHP + RLP) between the source terminal Hc and the ground G2 has a large resistance value exceeding the maximum resistance value allowed (i.e., when the contact is bad). On the contrary, the comparator COM4 outputs the low (low voltage) determination signal S4 when the contact resistance (RHP + RLP) is a small resistance value less than or equal to the maximum resistance value allowed (i.e., when the contact is good).

As an example, the comparator COM5 is configured by an operational amplifier, has a threshold voltage Vth5 of a voltage defined in advance set to the inverting input terminal by the processing unit CONT, and outputs, when the voltage V5 output from the low pass filter LPF5 and input to the non-inverting input terminal exceeds the voltage value of the threshold voltage Vth5, a high (high voltage) determination signal S5. In this case, since the voltage V5 is obtained by detecting the voltage (i.e., the magnitude of the AC voltage corresponding to the frequency f5 of the output AC current Io) generated between the source terminal Hc and the ground G2 based on the output AC current Io having the frequency f5 among the voltages included in the detection voltage Vd3, the voltage value is a value (∝ RHC + Rx + RLC) proportional to the series combined resistance (RHC + Rx + RLC) of the internal resistance Rx of the battery BAT, and the contact resistance RHC and the contact resistance RLC. Furthermore, when contact resistance (RHC + RLC) >> internal resistance (Rx), the voltage V5 has a voltage value indicating the magnitude of the contact resistance (RHC + RLC). Therefore, by defining the threshold voltage Vth5 to a voltage value corresponding to the maximum resistance value allowed for the contact resistance (RHC + RLC), the comparator COM5 outputs the high determination signal S5 when the contact resistance (RHP + RLP) between the source terminal Hc and the ground G2 has a large resistance value exceeding the maximum resistance value allowed (i.e., when the contact is bad). On the contrary, the comparator COM5 outputs the low (low voltage) determination signal S5 when the contact resistance (RHP + RLP) is a small resistance value less than or equal to the maximum resistance value allowed (i.e., when the contact is good). Note that usually, resistance value R4 of the feedback resistance R4 >> the contact resistance (RHP + RLP), and thus the presence of the resistance value R4 is ignored. When the contact resistance (RHP + RLP) is a large resistance value exceeding the maximum resistance value allowed, the presence of the resistance value R5 is ignored because contact resistance (RHC + RLC) >> the resistance value R5 of the ground resistance R5.

The measurement unit MU is configured by a synchronous detection circuit SDR, a low pass filter LPFR, and an A/D converter AD1 in addition to the configuration of the contact resistance measurement device 1 described above. In addition to the functions described above in the contact resistance measurement device 1, the processing unit CONT outputs the threshold voltage Vth4 to the synchronous detection circuit SD4, outputs the threshold voltage Vth5 to the synchronous detection circuit SD5, receives the determination signals S4 and S5 from the comparators COM4 and COM5, respectively, and receives a voltage signal SR to be described below from the A/D converter AD1. In addition, the processing unit CONT executes the quality determination process for the determination target contact part (in the present example, between the source terminal Hc and the source terminal Lc, and between the sense terminal Hp and the sense terminal Lp) based on the determination signals S1 to S5, also serves as a measurement unit that measures (calculates) the internal resistance Rx of the battery BAT, and measures the internal resistance Rx (an example of impedance) of the battery BAT serving as a measurement target based on the voltage signal SR.

The synchronous detection circuit SDR is configured using a multiplier as an example, and outputs a voltage VR including a DC voltage whose voltage value changes according to a voltage value (e.g., amplitude) of the AC voltage based on the output AC current Io having the frequency f4 among the AC voltages constituting the detection voltage Vd2 by multiplying the detection voltage Vd2 that is the AC voltage detected by the first amplifier A1 and output via the filter FIL1 and the synchronization signal Sf4 that is output from the AC current source SS2 with each other (in other words, synchronously detecting the detection voltage Vd2 output from the filter FIL1 with the synchronization signal Sf4). In addition, the low pass filter LPFR is configured as a low pass filter, receives the voltage VR output from the synchronous detection circuit SDR, removes an AC component for smoothing, and outputs the voltage VR as a DC voltage whose voltage value changes according to the voltage value of the detection voltage Vd2 having the frequency f4. That is, the synchronous detection circuit (the synchronous detection circuit SDR and the low pass filter LPFR) detects the magnitude of the detection voltage Vd2 corresponding to the frequency f4 of the output AC current Io.

The A/D converter AD1 A/D converts the voltage VR output from the low pass filter LPFR, and outputs, to the processing unit CONT, a voltage signal SR indicating a voltage value proportional to the magnitude of the internal resistance Rx of the battery BAT.

In addition to the functions described above, the output unit OUT displays the quality of the contact between the source terminal Hc and the source terminal Lc as the determination target contact part. Furthermore, when the display data Sd including data for displaying the contact resistance (RHC + RLC) and the internal resistance Rx of the battery BAT is input, the resistance values of the contact resistance (RHP + RLP) and the internal resistance Rx are displayed. In addition, when the output unit OUT is configured with an external interface circuit, the output unit OUT outputs the quality of the contact of the determination target contact part, and the resistance values of the contact resistances (RHC + RLC) and (RHP + RLP) and the internal resistance Rx to an external device connected with a transmission path via the external interface circuit, and when the output unit OUT is configured with a medium interface circuit, the output unit OUT causes a storage medium connected to the medium interface circuit to store the quality of the contact of the determination target contact part, and the resistance values of the contact resistances (RHC + RLC) and (RHP + RLP) and the internal resistance Rx.

Next, operations of the impedance measurement device 100 will be described. Note that for the same operation as that of the contact resistance measurement device 1 described above, redundant description will be omitted. In addition, it is assumed that the source terminal Hc and the source terminal Lc are respectively connected to the positive electrode terminal T1 and the negative electrode terminal T2 of the battery BAT via two measurement cables (not illustrated), and the sense terminal Hp and the sense terminal Lp are respectively connected to the positive electrode terminal T1 and the negative electrode terminal T2 of the battery BAT via two measurement cables (not illustrated). In addition, the contact resistance between the source terminal Hc and the positive electrode terminal T1 of the battery BAT and the wiring resistance of the measurement cable are referred to as a contact resistance RHC, and the contact resistance between the source terminal Lc and the negative electrode terminal T2 of the battery BAT and the wiring resistance of the measurement cable are referred to as a contact resistance RLC. Furthermore, the wiring resistance of the measurement cable is ignored in the description of present example because it is a small resistance.

At the time of impedance measurement, the processing unit CONT outputs a start signal to the measurement AC current source PM and the AC current source SS1, and the processing unit CONT outputs the threshold voltages Vth1 to Vth5 corresponding to the comparators COM1 to COM5. At this time, the measurement AC current source PM outputs the output AC current Io to start supplying the output AC current Io obtained by combining the AC currents having the frequencies f4 and f5 to a current path including the determination target contact parts between the source terminal Hc and the positive electrode terminal T1 of the battery BAT and between the source terminal Lc and the negative electrode terminal T2 of the battery BAT. At this time, the output AC current Io flows through a current path including the output terminal of the operational amplifier OP2, the capacitor C4, the source terminal Hc, the battery BAT, the source terminal Lc, the ground resistance R5, and the ground G2. Furthermore, the AC current source SS2 outputs the synchronization signal Sf4 to the synchronous detection circuits SD4 and SDR, and outputs the synchronization signal Sf5 to the synchronous detection circuit SD5. As a result, by the output AC current Io being supplied between the source terminal Hc and the source terminal Lc, an AC voltage is generated due to the flow of the output AC current Io having the frequencies f4 and f5 to the determination target contact parts between the source terminal Hc and the positive electrode terminal T1 of the battery BAT and between the negative electrode terminal T2 of the battery BAT and the source terminal Lc. In this case, the generated AC voltage is input as a detection voltage Vd3 to the synchronous detection circuits SD4 and SD5 via the capacitor C3.

Next, the synchronous detection circuit SD4 synchronously detects the input detection voltage Vd3 with the synchronization signal Sf4 output from the AC current source SS2, and outputs a voltage V4 whose voltage value changes according to the voltage value (e.g., amplitude) of the AC voltage based on the output AC current Io having the frequency f4 among the AC voltages constituting the detection voltage Vd3. Thereafter, the low pass filter LPF4 receives the voltage V4 output from the synchronous detection circuit SD4, removes the AC component for smoothing, and outputs the voltage V4 that is the DC voltage to the non-inverting terminal of the comparator COM4. Furthermore, the synchronous detection circuit SD5 synchronously detects the input detection voltage Vd3 with the synchronization signal Sf5 output from the AC current source SS2, and outputs a voltage V5 whose voltage value changes according to the voltage value (e.g., amplitude) of the AC voltage based on the output AC current Io having the frequency f5 among the AC voltages constituting the detection voltage Vd3. Thereafter, the low pass filter LPF5 receives the voltage V5 output from the synchronous detection circuit SD4, removes the AC component for smoothing, and outputs the voltage V2 that is the DC voltage to the non-inverting terminal of the comparator COM5.

Next, as a part of the quality determination process, the comparator COM4 compares the voltage V4 input to the non-inverting terminal with the threshold voltage Vth4 input to the inverting terminal, outputs a high (high voltage) determination signal S4 when the voltage V4 exceeds the voltage value of the threshold voltage Vth4, and outputs a low (low voltage) determination signal S4 to the processing unit CONT when the voltage V4 is less than or equal to the voltage value of the threshold voltage Vth4. Similarly, as a part of the quality determination process, the comparator COM5 compares the voltage V5 input to the non-inverting terminal with the threshold voltage Vth5 input to the inverting terminal, outputs a high (high voltage) determination signal S5 when the voltage V5 exceeds the voltage value of the threshold voltage Vth5, and outputs a low (low voltage) determination signal S5 to the processing unit CONT when the voltage V5 is less than or equal to the voltage value of the threshold voltage Vth5.

Next, the processing unit CONT executes the quality determination process described above based on the input determination signals S1 to S3. Specifically, the processing unit CONT ultimately determines the quality of the contact resistance of the determination target contact parts between the sense terminal Hp and the positive electrode terminal T1 of the battery BAT and between the source terminal Hc and the negative electrode terminal T2 of the battery BAT as the quality determination process based on the result of the comparison between the voltages V1 to V3 and the threshold voltages Vth1 to Vth3 by the comparators COM1 to COM3, respectively (the determination process which is a process of a part of the quality determination process).

Furthermore, the processing unit CONT executes the quality determination process for each of the different frequencies f4 and f5 based on the input determination signals S4 and S5. Specifically, the processing unit CONT ultimately determines the quality of the contact resistance of the determination target contact parts between the source terminal Hc and the positive electrode terminal T1 of the battery BAT and between the source terminal Lc and the negative electrode terminal T2 of the battery BAT as the quality determination process based on the result of the comparison between the voltages V4 and V5 and the threshold voltages Vth4 and Vth5 by the comparators COM4 and COM5, respectively (the determination process which is a process of a part of the quality determination process). More specifically, as the quality determination process, the processing unit CONT ultimately determines that the contact resistance of the determination target contact part is good when the contact resistance of the determination target contact part is a small resistance value (i.e., when determined to be good) less than or equal to a resistance value defined in advance (resistance values corresponding to threshold voltages Vth4 and Vth5) in more than half the number of times (in this example, two times, which is also the total number of times) of the plurality of times (in this example, two times) of determination process executed by the comparators COM4 and COM5 executed for each of the different frequencies f4 and f5, and ultimately determines that the contact resistance of the determination target contact part is bad when the contact resistance of the determination target contact part is a small resistance value less than or equal to a resistance value defined in advance (resistance values corresponding to threshold voltages Vth4 and Vth5) in less than half (in this example, one time or less) of the plurality of times (in this example, two times) of determination process by the comparators COM4 and COM5. By executing the quality determination process in this manner, even when noise having a frequency that is the same as or in the vicinity of a plurality of frequencies (e.g., frequency f5) is generated in the environment around the contact resistance measurement device 1, the impedance measurement device 100 (processing unit CONT) can accurately perform the contact check as a contact check by another frequency (in this example, the frequency f4) is not affected.

Thereafter, the processing unit CONT outputs the final determination result of the quality determination process to the output unit OUT as the display data Sd. Next, based on the display data Sd, the output unit OUT displays whether or not the contact resistance (RHC + RLC, RHP + RLP) of the determination target contact part is a resistance value smaller than the maximum resistance value allowed, that is, the quality of the contact resistance of the determination target contact part.

Note that it is also possible to adopt a configuration in which the processing unit CONT includes only determination results of a plurality of times (in this example, three times) of determination process by the comparators COM1 to COM3 and a plurality of times (in this example, two times) of determination process by the comparators COM4 and COM5 in the display data Sd and outputs the data to the output unit OUT. When this configuration is adopted, the measurer makes a determination based on the determination result of the determination process.

Next, when the resistance value of the contact resistance of the determination target contact part is good, the processing unit CONT automatically executes the impedance measurement process of the internal resistance Rx of the battery BAT. In this case, an AC voltage is generated due to the output AC current Io flowing inside the battery BAT. At this time, the generated AC voltage is input as a detection voltage Vd2 to the non-inverting input terminal of the operational amplifier OP1 via the capacitor C2. Next, the first amplifier A1 amplifies the input detection voltage Vd2 with a prescribed amplification factor and outputs the amplified detection voltage Vd2 to the filter FIL1. Next, the filter FIL1 receives the detection voltage Vd2 output from the first amplifier A1, and passes, as the detection voltage Vd2, AC voltages that are frequency components of the frequencies f1, f2, f3 and f4 included in the detection voltage Vd2 while removing frequency components (noise components) outside the pass band included in the detection voltage Vd2. Thereafter, the detection voltage Vd2, which is the frequency components of the frequencies f1, f2, f3, and f4 that have passed the filter FIL1, is input to the synchronous detection circuits SD1 to SD3, and SDR.

Furthermore, the synchronous detection circuit SDR synchronously detects the input detection voltage Vd2 with the synchronization signal Sf4 output from the AC current source SS2, and outputs a voltage VR whose voltage value changes according to the voltage value (e.g., amplitude) of the AC voltage based on the output AC current Io having the frequency f4 among the AC voltages constituting the detection voltage Vd2. Thereafter, the low pass filter LPFR receives the voltage VR output from the synchronous detection circuit SDR, removes AC components to smooth the voltage VR, and outputs the voltage VR that is a DC voltage to the A/D converter AD1. Next, the A/D converter AD1 A/D converts the voltage VR output from the low pass filter LPFR and outputs a voltage signal SR to the processing unit CONT. In this case, since the voltage VR is obtained by detecting a voltage (i.e., the magnitude of the AC voltage corresponding to the frequency f4 of the output AC current Io)generated between the sense terminal Hp and the sense terminal Lp based on the output AC current Io having the frequency f4 among the voltages included in the detection voltage Vd2, the voltage value thereof is a value proportional to the internal resistance Rx of the battery BAT (∝ Rx). Therefore, the voltage signal SR is a measurement value indicating a value proportional to the internal resistance Rx of the battery BAT.

Next, the processing unit CONT calculates the internal resistance Rx of the battery BAT by dividing the measurement value indicated by the voltage signal SR by the known current value of the output AC current Io. Thereafter, the processing unit CONT displays the internal resistance Rx of the battery BAT on the output unit OUT by outputting the display data Sd.

As described above, according to the impedance measurement device 100, similarly to the contact resistance measurement device 1, the processing unit CONT executes the quality determination process for each of the frequencies f1, f2, and f3 and executes the quality determination process for each of the frequencies f4 and f5. As a result, even when noise having a frequency that is the same as or in the vicinity of one or a plurality of frequencies (e.g., the frequencies f1 and f5) is generated in the environment around the impedance measurement device 100, the impedance measurement device 100 (processing unit CONT) can accurately perform the contact check, and as a result, sufficiently enhance the reliability of the impedance measurement as contact checks by other frequencies (in this example, the frequencies f2, f3, f4) are not affected.

In addition, according to the impedance measurement device 100, since the synchronous detection circuits (the synchronous detection circuits SD1 to SD3 and the low pass filters LPF1 to LPF3) as many as the different frequencies are used, similarly to the contact resistance measurement device 1, the quality determination process for each of the different frequencies by the processing unit CONT can be executed very quickly, and as a result, the impedance measurement time can be sufficiently shortened.

Furthermore, according to the impedance measurement device 100, the AC current source SS2 also serves as the first AC current source, and supplies, as one of the output AC currents Io serving as a plurality of contact determination AC currents having different frequencies f4 and f5, the output AC current Io serving as the measurement AC current to the current path including the contact parts between the source terminal Hc and the positive electrode terminal T1 that is one end and the negative electrode terminal T2 that is the other end of the battery BAT serving as the measurement target. Therefore, according to the impedance measurement device 100, since the second AC current source also serves as the first AC current source that supplies the contact determination AC current, it is not necessary to provide two first AC current sources, and as a result, the impedance measurement device 100 can be configured simply and inexpensively.

In addition, according to the impedance measurement device 100, when the processing unit CONT ultimately determines that the contact resistance of the determination target contact part is good, the processing unit CONT outputs the internal resistance Rx of the battery BAT measured by the measurement unit (the measurement unit MU and the processing unit CONT) to the output unit OUT. Therefore, according to this impedance measurement device, the reliability of impedance measurement can be sufficiently enhanced.

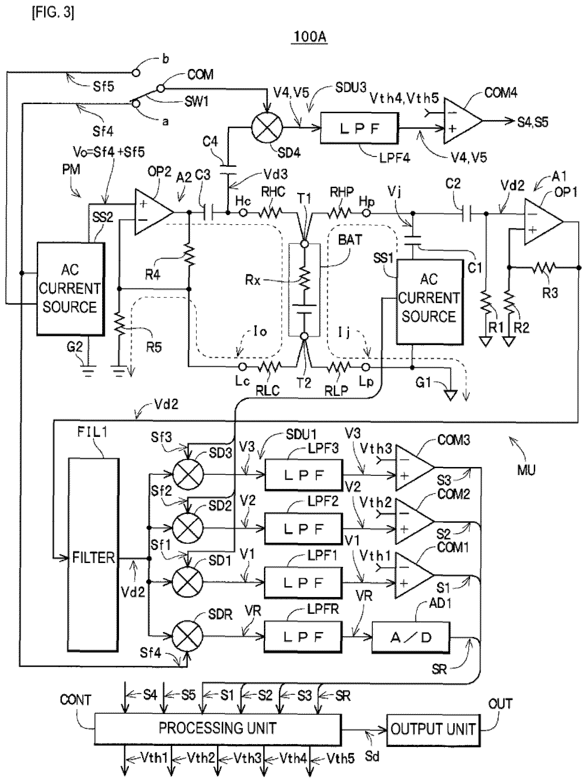

Next, an impedance measurement device 100A serving as another impedance measurement device will be described with reference to FIG. 3. Note that the same components as those of the impedance measurement device 100 are denoted by the same reference numerals, and redundant description will be omitted.

The impedance measurement device 100A includes a synchronous detection unit SDU3 instead of the synchronous detection unit SDU2 in the impedance measurement device 100, and does not include the comparator COM5. In this case, the synchronous detection unit SDU3 includes a switch SW1, a synchronous detection circuit SD4, and a low pass filter LPF4. In the impedance measurement device 100A, the processing unit CONT sequentially executes the switching control of the switch SW1 and the output switching control of the threshold voltages Vth4 and Vth5 with respect to the comparator COM4 in conjunction with the switching control of the switch SW1.

The switch SW1 includes a common (COM) contact, an a-contact, and a b-contact, and switches the connection between the COM contact and the a-contact and the connection between the COM contact and the b-contact to either one according to the switching control of the processing unit CONT. In this case, the synchronization signal Sf4 from the AC current source SS2 is input to the a-contact and the synchronization signal Sf5 from the AC current source SS2 is input to the b-contact. Furthermore, the COM contact of the switch SW1 is connected to a synchronization signal input of the synchronous detection circuit SD4. Therefore, the switch SW1 outputs one of the synchronization signal Sf4 and the synchronization signal Sf5 to the synchronous detection circuit SD4 according to the switching control of the processing unit CONT.

In addition, the comparator COM4 sequentially and synchronously detects the detection voltage Vd3 with the synchronization signals Sf4 and Sf5 having the same frequencies f4 and f5 as the different frequencies f4 and f5, respectively, of the detection voltage Vd3, thereby sequentially outputting the voltages V4 and V5 that are the DC voltage whose voltage values change according to the voltage values of the detection voltage Vd3 corresponding to the different frequencies f4 and f5. Specifically, when the threshold voltage Vth4 is output from the processing unit CONT to the inverting terminal, the comparator COM4 outputs the high (high voltage) determination signal S4 when the voltage V4 output from the low pass filter LPF4 and input to the non-inverting input terminal exceeds the voltage value of the threshold voltage Vth4. On the other hand, when the threshold voltage Vth5 is output from processing unit CONT to the inverting terminal, high (high voltage) determination signal S4 is output when voltage V5 output from low pass filter LPF4 and input to the non-inverting input terminal exceeds the voltage value of threshold voltage Vth5.

Next, operations of the impedance measurement device 100A will be described. The same operations as those of the contact resistance measurement device 1 and the impedance measurement device 100 described above will not be described repeatedly.

In the impedance measurement device 100A, when the quality determination process is executed on the determination target contact part, the processing unit CONT executes the switching control on the switch SW1 and executes the output switching control of the threshold voltages Vth4 and Vth5 with respect to the comparator COM4 in conjunction with the switching control. Specifically, the processing unit CONT outputs the threshold voltage Vth4 to the comparator COM4 when executing connection control (hereinafter, also referred to as "connection control A") of connecting the COM contact and the a-contact, on the switch SW1. In this case, the synchronization signal Sf4 output from the AC current source SS2 is output to the synchronous detection circuit SD4 via the a-contact and the COM contact of the switch SW1. At this time, the synchronous detection circuit SD4 synchronously detects the input detection voltage Vd3 with the synchronization signal Sf4, and outputs a voltage V4 whose voltage value changes according to the voltage value (e.g., amplitude) of the AC voltage based on the output AC current Io having the frequency f4 among the AC voltages constituting the detection voltage Vd3. Thereafter, the low pass filter LPF4 receives the voltage V4 output from the synchronous detection circuit SD4, removes the AC component for smoothing, and outputs the voltage V4 that is the DC voltage to the non-inverting terminal of the comparator COM4. Next, as a part of the quality determination process, the comparator COM4 compares the voltage V4 input to the non-inverting terminal with the threshold voltage Vth4 input to the inverting terminal, and outputs a high (high voltage) determination signal S4 when the voltage V4 exceeds the voltage value of the threshold voltage Vth4, and outputs a low (low voltage) determination signal S4 to the processing unit CONT when the voltage V4 is less than or equal to the voltage value of the threshold voltage Vth4.

On the other hand, when the connection control (hereinafter, also referred to as "connection control B") of connecting the COM contact and the b-contact, on the switch SW1 is sequentially executed after the execution of the connection control A, the processing unit CONT outputs the threshold voltage Vth5 to the comparator COM4. In this case, the synchronization signal Sf5 output from the AC current source SS2 is output to the synchronous detection circuit SD4 via the b-contact and the COM contact of the switch SW1. At this time, the synchronous detection circuit SD4 synchronously detects the input detection voltage Vd3 with the synchronization signal Sf5, and outputs a voltage V5 whose voltage value changes according to the voltage value (e.g., amplitude) of the AC voltage based on the output AC current Io having the frequency f5 among the AC voltages constituting the detection voltage Vd3. Thereafter, the low pass filter LPF4 receives the voltage V5 output from the synchronous detection circuit SD4, removes the AC component for smoothing, and outputs the voltage V5 that is the DC voltage to the non-inverting terminal of the comparator COM4. Next, as a part of the quality determination process, the comparator COM4 compares the voltage V4 input to the non-inverting terminal with the threshold voltage Vth5 input to the inverting terminal, and outputs a high (high voltage) determination signal S5 when the voltage V5 exceeds the voltage value of the threshold voltage Vth5, and outputs a low

(low voltage) determination signal S4 to the processing unit CONT when the voltage V5 is less than or equal to the voltage value of the threshold voltage Vth5.

Furthermore, the processing unit CONT executes the quality determination process for each of the different frequencies f4 and f5 based on the input determination signals S4 and S5. Specifically, the processing unit CONT ultimately determines the quality of the contact resistance of the determination target contact parts between the source terminal Hc and the positive electrode terminal T1 of the battery BAT and between the source terminal Lc and the negative electrode terminal T2 of the battery BAT as the quality determination process, similarly to the quality determination process by the impedance measurement device 100 described above, based on the result of the comparison between the voltage V4 and the threshold voltage Vth4 by the comparator COM4 when the connection control A is executed (determination process that is a process of a part of the quality determination process) and the result of the comparison between the voltage V5 and the threshold voltage Vth5 by the comparator COM4 when the connection control B is executed (determination process that is a process of a part of the quality determination process).

Thereafter, the processing unit CONT outputs the final determination result of the quality determination process to the output unit OUT as the display data Sd. Next, based on the display data Sd, the output unit OUT displays whether or not the contact resistance (RHC + RLC, RHP + RLP) of the determination target contact part is a resistance value smaller than the maximum resistance value allowed, that is, the quality of the contact resistance of the determination target contact part.

Next, when the resistance value of the contact resistance of the determination target contact part is good, the processing unit CONT executes impedance measurement process of the internal resistance Rx of the battery BAT and output control of outputting the display data Sd to the output unit OUT, similarly to the impedance measurement device 100.

As described above, according to the impedance measurement device 100A, similarly to the impedance measurement device 100, the processing unit CONT executes the quality determination process for each of the frequencies f1, f2, and 3 and executes the quality determination process for each of the frequencies f4 and f5. As a result, even when noise having a frequency that is the same as or in the vicinity of one or a plurality of frequencies (e.g., the frequencies f1 and f5) is generated in the environment around the impedance measurement device 100A, the impedance measurement device 100A (processing unit CONT) can accurately perform the contact check, and as a result, sufficiently enhance the reliability of the impedance measurement as contact checks by other frequencies (in this example, the frequencies f2, f3, f4) are not affected.

Furthermore, in the impedance measurement device 100A (contact resistance measurement device 1), the synchronous detection unit SD3 is configured using one switch SW1 and one synchronous detection circuit configured by the synchronous detection circuit SD4 and the LPF. The synchronous detection unit SD3 sequentially and synchronously detects the detection voltage Vd3 with the synchronization signals Sf4 and Sf5 having the same frequency as the different frequencies f4 and f5 of the detection voltage Vd3, respectively, to sequentially output the voltages V4 and V5 whose voltage values change according to the voltage values of the detection voltage Vd3 corresponding to the different frequencies f4 and f5, respectively. The processing unit CONT executes the quality determination process for each of the different frequencies f4 and f5. Therefore, according to the impedance measurement device 100A, the synchronous detection unit SDU3 can be configured simply and inexpensively as compared with a case where the synchronous detection unit is configured including a plurality of synchronous detection circuits provided in one-to-one correspondence with the different frequencies f4 and f5.

Note that in the impedance measurement device 100 and 100A, the AC current source SS2 combines the output AC currents Io at the different frequencies f4 and f5 and outputs the combined output AC current Io, but it is not limited to this configuration. A configuration can be adopted in which the output AC current Io at the frequency f4 and the output AC current Io at the frequency f5 are sequentially output without being combined in synchronization with the switching control of the switch SW1 according to the switching control of the processing unit CONT. In addition, in the impedance measurement device 100 and 100A, the AC current source SS2 that outputs the output AC current Io having the frequency f4 that serves as both the measurement AC current and the contact determination AC current has been described as an example, but the frequency of the contact determination AC current and the frequency of the measurement AC current may be different from each other. However, according to the configuration in which the measurement AC current and the contact determination AC current are used together, the AC current source SS2 (the first AC signal power supply and the second AC signal power supply) can be configured more simply and inexpensively.

In the impedance measurement device 100 and 100A, both the current path including the contact parts between the source terminal Hc and the positive electrode terminal T1 of the battery BAT and between the source terminal Lc and the negative electrode terminal T2 of the battery BAT and the current path including the contact parts between the sense terminal Hp and the positive electrode terminal T1 of the battery BAT and between the sense terminal Lp and the negative electrode terminal T2 of the battery BAT are set as the determination target contact parts, but it is not limited thereto. As the impedance measurement device, a configuration can be adopted in which although the accuracy of the contact check decreases, the quality determination process is executed with each contact part in either one of the current paths as a determination target contact part.

In addition, as the quality determination process, an example has been described in which the processing unit CONT ultimately determines that the contact resistance of the determination target contact part is good when the processing unit CONT determines that the contact resistance is good in more than half the number of times of the three determination processes, and an example has been described in which the processing unit CONT ultimately determines that the contact resistance of the determination target contact part is bad when the processing unit CONT determines that the contact resistance is bad in all the determination processes, but it is not limited thereto. Although the accuracy of the contact check decreases, for example, when the quality determination process is executed even number of times, the processing unit CONT may ultimately determine that the contact resistance of the determination target contact part is good when determining that the contact resistance is good in half or more of the determination processes of even number of times. In addition, the processing unit CONT may ultimately determine that the contact resistance of the determination target contact part is good when determined to be good in one or more number of times defined in advance among the plurality of times of determination processes. Such determination enables contact check even when noise is generated in a wide frequency region in the environment around the contact resistance measurement device 1.

Furthermore, the contact resistance measurement device is not limited to the application to the impedance measurement device. For example, the contact resistance measurement device can be widely applied to a measurement device such as an ammeter, a voltmeter, a wattmeter, or a resistance meter, a power device that supplies a current or applies a voltage, or the like that requires a quality determination process for a determination target contact part when a contact target is brought into contact with a terminal, a probe, or the like. In the impedance measurement device, the measurement target is not limited to the battery BAT, and all the devices having the internal resistance Rx can be set as the measurement target.

In addition, an example in which the filter FIL1, the synchronous detection units SDU1, SUD2, and SUD3, the comparators COM1 to COM5, the low pass filter LPFR, and the A/D converter AD1 are configured separately from the processing unit CONT has been described, but the processing unit CONT can execute some or all the functions of these components by digital processing.

### INDUSTRIAL APPLICABILITY

According to the present invention, in the contact resistance measurement device including the processing unit that executes the quality determination process on the determination target contact part, the plurality of contact determination AC currents having different frequencies are supplied to the current path including the determination target contact part, and the processing unit executes the quality determination processing for each of the different frequencies, whereby the contact check can be accurately performed. Furthermore, the impedance measurement device including such a contact resistance measurement device can sufficiently enhance the reliability of impedance measurement. Thus, the present invention can be widely applied to such a contact resistance measurement device, an impedance measurement device that performs impedance measurement, and the like.

### REFERENCE SIGNS LIST

1 Contact resistance measurement device
100, 100A Impedance measurement device
A1 First amplifier
A2 Second amplifier
AD1 A/D conversion circuit
BAT Battery
COM1 to COM5 Comparator
CONT Processing unit
FIL1 Filter
Hc, Lc Source terminal
Hp, Lp Sense terminal
Ij Determination current
Io Output AC current
LPF1 to LPF5, LPFR Low pass filter
OUT Output unit
RHC, RLC, RHP, RLP Contact resistance
Rx Internal resistance
S1 to S5 Determination signal
SD1 to SD5 Synchronous detection circuit
Sf1 to Sf5 Synchronization signal
SS1, SS2 AC current source
V1 to V5 Voltage
Vd1 to Vd3 Detection voltage
Vth1 to Vth5 Threshold voltage
T1 Positive electrode terminal
T2 Negative electrode terminal

## Claims

1. A contact resistance measurement device comprising:
a first AC current source configured to supply a contact determination AC current to a current path including a determination target contact part;
a synchronous detection unit configured to synchronously detect an AC voltage corresponding to a frequency of the contact determination AC current and generated at the determination target contact part when the contact determination AC current is supplied from the first AC current source with a synchronization signal having a frequency identical to the frequency of the AC voltage and output a DC voltage whose voltage value changes according to a voltage value of the AC voltage; and
a processing unit configured to execute a quality determination process for the determination target contact part based on the DC voltage output from the synchronous detection unit, wherein
the first AC current source is configured to be able to supply a plurality of the contact determination AC currents defined at different frequencies to the current path,
the synchronous detection unit synchronously detects a plurality of the AC voltages generated at the determination target contact part when the plurality of the contact determination AC currents are supplied to the current path with the synchronization signals respectively having frequencies each identical to the corresponding one of the different frequencies of the plurality of the AC voltages, and outputs a plurality of the DC voltages whose voltage values change according to voltage values of the plurality of the AC voltages corresponding to the different frequencies, and
the processing unit executes the quality determination process for each of the different frequencies.

2. The contact resistance measurement device according to claim 1, wherein
the first AC current source is configured to be able to combine the plurality of the contact determination AC currents respectively having the different frequencies and supply the combined contact determination AC current to the current path,
the synchronous detection unit is configured including a plurality of synchronous detection circuits provided in a one-to-one correspondence with the different frequencies,
each of the plurality of synchronous detection circuits synchronously detects the AC voltage having a frequency corresponding to the different frequencies on a one-to-one basis with the synchronization signal having a frequency identical to the frequency of the AC voltage, and outputs the DC voltage whose voltage value changes according to the voltage value of the AC voltage corresponding to the frequency, and
the processing unit executes the quality determination process for each of the different frequencies.

3. The contact resistance measurement device according to claim 1, wherein the synchronous detection unit sequentially and synchronously detects each of the plurality of the AC voltages with a synchronization signal having a frequency identical to the corresponding one of the different frequencies of the plurality of the AC voltages, and sequentially outputs a DC voltage whose voltage value changes according to a voltage value of each of the plurality the AC voltages corresponding to the different frequencies, and
the processing unit executes the quality determination process for each of the different frequencies.

4. The contact resistance measurement device according to claim 1, wherein the processing unit executes, as the quality determination process, a determination process for determining that a contact resistance of the determination target contact part is good for each of the different frequencies when the contact resistance of the determination target contact part is smaller than a resistance value defined in advance, and ultimately determines that the contact resistance of the determination target contact part is good when determined to be good for more than half the number of times of the executed determination process.

5. The contact resistance measurement device according to claim 1, wherein the processing unit executes, as the quality determination process, a determination process for determining that the contact resistance of the determination target contact part is good for each of the different frequencies when the contact resistance of the determination target contact part is smaller than a resistance value defined in advance, and ultimately determines that the contact resistance of the determination target contact part is bad when determined to be bad in all the executed determination processes.

6. An impedance measurement device including,
a second AC current source configured to supply a measurement AC current to a measurement target, the measurement target having one end and the other end connected to a Hi side source terminal and a Lo side source terminal, respectively; and
a measurement unit configured to measure an AC voltage generated between the one end and the other end of the measurement target via a sense terminal for signal detection on Hi side and a sense terminal for signal detection on Lo side connected to the one end and the other end, respectively, when the measurement AC current is supplied and measure an impedance of the measurement target based on a voltage value of the measured AC voltage and a current value of the measurement AC current, the impedance measurement device comprising:
the contact resistance measurement device according to any one of claims 1 to 5, wherein
the first AC current source supplies the contact determination AC current to at least one current path among the current path including contact parts between the Hi side source terminal and the one end of the measurement target and between the Lo side source terminal and the other end of the measurement target and the current path including contact parts between the sense terminal for signal detection on Hi side and the one end of the measurement target and between the sense terminal for signal detection on Lo side and the other end of the measurement target; and
the processing unit executes, for each of the different frequencies, the quality determination process in which each of the contact parts in the at least one current path is regarded as the determination target contact part.

7. The impedance measurement device according to claim 6, wherein the second AC current source also serves as the first AC current source, and supplies the measurement AC current as one of the plurality of the contact determination AC currents having different frequencies to the current path including the contact parts between the Hi side source terminal and the one end of the measurement target and between the Lo side source terminal and the other end of the measurement target.

8. The impedance measurement device according to claim 6, further comprising:
the contact resistance measurement device according to claim 4 as the contact resistance measurement device; wherein
the processing unit outputs an impedance of the measurement target measured by the measurement unit when the processing unit ultimately determines that the contact resistance of the determination target contact part is good.

9. The impedance measurement device according to claim 6, further comprising:
the contact resistance measurement device according to claim 5 as the contact resistance measurement device; wherein
the processing unit outputs an impedance of the measurement target measured by the measurement unit when the processing unit ultimately determines that the contact resistance of the determination target contact part is good.
